(19) Europäisches Patentamt
European Patent Office
Office européen des brevets

(11) EP 4 678 710 A1

(12) EUROPEAN PATENT APPLICATION
published in accordance with Art. 153(4) EPC

(43) Date of publication:
14.01.2026 Bulletin 2026/03

(21) Application number: 24770804.3

(22) Date of filing: 08.03.2024

(51) International Patent Classification (IPC):
*C09J 183/04* (2006.01) *H01L 21/304* (2006.01)

(52) Cooperative Patent Classification (CPC):
**C09J 183/04; H01L 21/304**

(86) International application number:
**PCT/JP2024/009169**

(87) International publication number:
**WO 2024/190698 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.03.2023 JP 2023037773**

(71) Applicant: **SHIN-ETSU CHEMICAL CO., LTD.**
**Tokyo 1000005 (JP)**

(72) Inventors:
- **KASABATA, Koki**
**Annaka-shi, Gunma 379-0224 (JP)**
- **SUGO, Michihiro**
**Annaka-shi, Gunma 379-0224 (JP)**
- **YAMAKI, Masahiro**
**Annaka-shi, Gunma 379-0224 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

# (54) TEMPORARY ADHESION MATERIAL COMPOSITION AND SUBSTRATE CLEANING METHOD

(57) The present invention provides a temporary adhesive material composition for detachably bonding a substrate and a support, containing: (A) an organopolysiloxane mixture that undergoes hydrosilylation reaction for crosslinking; (B) an organopolysiloxane that undergoes no hydrosilylation reaction; (C) a catalyst; and (D) an organic solvent, in which when the temporary adhesive material composition is passed through a filtration filter having a pore size of 100 nm or less, the number of particles remaining after the filtration and having a particle size of 100 nm or more and 1000 nm or less is 20 particles/ml or less. As a result, temporary adhesive material composition leaving few particles that may cause connection failure in a substrate surface (circuit-forming surface) after cleaning, is provided.

EP 4 678 710 A1

## Description

### TECHNICAL FIELD

The present invention relates to a temporary adhesive material composition and a method for cleaning a substrate.

### BACKGROUND ART

Three-dimensional semiconductor packaging has become essential to realize further higher density and larger capacity. Three-dimensional packaging technology refers to semiconductor fabrication technology for forming a semiconductor chip by reducing thickness of a semiconductor chip and laminating the semiconductor chip one after another while connecting them by through-silicon via (TSV) to obtain a multi-layer. To realize this, it is required to perform a step of reducing the thickness of a substrate having a semiconductor circuit formed thereon by grinding a non-circuit-forming surface (also referred to as "back surface" in the specification) thereof, and a step of forming an electrode including TSV on the back surface. Conventionally, in the back-surface grinding step of a silicon substrate, a back-surface protection tape is attached onto the opposite surface of the grinding surface to prevent wafer breakage during grinding. However, the tape employs an organic resin film as a base material, so that it is flexible but insufficient in strength and heat resistance. Because of this, the tape is not suitable for use in a TSV forming step and a wiring-layer formation step on the back surface.

Then, it has been proposed to develop a system that can withstand the back-surface grinding step and the TSV and back-surface electrode formation step by joining a semiconductor substrate to, e.g., a silicon or glass support via an adhesive layer. What is important in the system is an adhesive layer for use in joining the substrate to the support. This makes it possible to join the substrate to the support without any gaps and is required to have sufficient durability to withstand later steps. This is further required to easily detach a thin wafer from the support at the end. Note that, since the adhesive layer is finally detached, the adhesive layer is also referred to as a "temporary adhesive layer" in the specification.

As a temporary adhesive layer and a detachment method thereof known in the technical field, a hot-melt joining/detachment technique using hot-melt hydrocarbon compound as an adhesive agent (Patent Document 1) has been proposed.

After the support is detached, a temporary adhesive material sometimes partly remains on a circuit-forming surface (hereinafter referred to as "front surface") of a substrate, on which a semiconductor circuit is formed. Usually, the remaining temporary adhesive layer is removed in a cleaning step.

Recently, a method of connecting copper electrodes formed on the same surface of the chip, one after another in a step of laminating semiconductor chips reduced in thickness, has been developed. In this method, since the ratio of voids between chips can be reduced, compared to a conventional method of connecting electrodes projecting on the surfaces of chips, it is expected to further increase density and decrease power consumption. However, in a method of connecting copper electrodes formed on the same surface of a chip, if a large particle remains between thin chips, it may cause connection failure between the chips.

In the circumstance, it has been desired to develop a temporary adhesive material composition leaving fewer particles that may cause connection failure in a substrate surface (circuit-forming surface) after cleaning and a cleaning method thereof.

### CITATION LIST

### PATENT LITERATURE

Patent Document 1: JP 2013-243350 A

### SUMMARY OF INVENTION

### TECHNICAL PROBLEM

The present invention has been made in consideration of the above problems. An object of the present invention is to provide a temporary adhesive material composition leaving fewer particles that may cause connection failure in a substrate surface (circuit-forming surface) after cleaning.

### SOLUTION TO PROBLEM

To solve the above problems, the present invention provides a temporary adhesive material composition for

detachably bonding a substrate and a support, including: (A) an organopolysiloxane mixture that undergoes hydrosilylation reaction for crosslinking; (B) an organopolysiloxane that undergoes no hydrosilylation reaction; (C) a catalyst; and (D) an organic solvent, wherein when the temporary adhesive material composition is passed through a filtration filter having a pore size of 100 nm or less, the number of particles remaining after the filtration and having a particle size of 100 nm or more and 1000 nm or less is 20 particles/ml or less.

According to the temporary adhesive material composition, it is possible to reduce the number of particles that may cause connection failure in a substrate surface (circuit-forming surface) after cleaning.

In this case, it is preferable that component (A) mentioned above is a mixture of different organopolysiloxanes (A-1) and (A-2); the component (A-1) is constituted of at least one of M unit represented by $R_1R_2R_3SiO_{1/2}$, D unit represented by $R_4R_5SiO_{2/2}$, T unit represented by $R_6SiO_{3/2}$, or Q unit represented by $SiO_{4/2}$, wherein substituents $R_1$, $R_2$, $R_3$, $R_4$, $R_5$, and $R_6$ are each a methyl group, $-CH=CH_2$ or a phenyl group, and the component (A-2) is constituted of at least one of M unit represented by $R_7R_8R_9SiO_{1/2}$, D unit represented by $R_{10}R_{11}SiO_{2/2}$, T unit represented by $R_{12}SiO_{3/2}$ or Q unit represented by $SiO_{4/2}$, wherein substituents $R_7$, $R_8$, $R_9$, $R_{10}$, $R_{11}$, and $R_{12}$ are each a methyl group, a phenyl group or hydrogen.

It is also preferable that the component (B) is constituted of at least one of M unit represented by $R_{13}R_{14}R_{15}SiO_{1/2}$, D unit represented by $R_{16}R_{17}SiO_{2/2}$, T unit represented by $R_{18}SiO_{3/2}$ or Q unit represented by $SiO_{4/2}$, wherein substituents $R_{13}$, $R_{14}$, $R_{15}$, $R_{16}$, $R_{17}$, and $R_{18}$ are each a methyl group or a phenyl group.

The component (C) is preferably a platinum catalyst.

The component (D) is preferably an organic solvent containing at least one saturated hydrocarbon having 8 to 12 carbon atoms and containing no heteroatoms.

The temporary adhesive material composition containing these components can more securely leave fewer particles that may cause connection failure in a substrate surface (circuit-forming surface) after cleaning.

The present invention also provides a method for cleaning a substrate, including the steps of: attaching an adhesive sheet so as to entirely cover a temporary adhesive material composition on a substrate and detaching the adhesive sheet, thereby removing the temporary adhesive material composition; cleaning the substrate with cleaning solution A; rinsing the substrate with cleaning solution B, and rinsing the substrate with cleaning solution C.

According to the cleaning method through these steps, it is possible to obtain a substrate having fewer particles that may cause connection failure in a surface (circuit-forming surface) of the substrate after cleaning.

In this case, it is preferable that the cleaning solution A is a cleaning solution containing a quaternary ammonium salt, and that when the cleaning solution A is passed through a filtration filter having a pore size of 100 nm or less, the number of particles remaining after the filtration and having a particle size of 100 nm or more and 1000 nm or less is 3.0 particles/ml or less.

It is also preferable that the cleaning solution B is a cleaning solution containing a water-soluble organic solvent, and that when the cleaning solution B is passed through a filtration filter having a pore size of 100 nm or less, the number of particles remaining after the filtration and having a particle size of 100 nm or more and 1000 nm or less is 3.0 particles/ml or less.

It is also preferable that the cleaning solution C is water, and that when the cleaning solution C is passed through a filtration filter having a pore size of 100 nm or less, the number of particles remaining after the filtration and having a particle size of 100 nm or more and 1000 nm or less is 3.0 particles/ml or less.

When these cleaning solutions are used, it is possible to more effectively obtain a substrate having fewer particles that may cause connection failure in a surface (circuit-forming surface) of the substrate after cleaning.

In the method for cleaning a substrate of the present invention, it is preferable that after the substrate on which the temporary adhesive material composition is present is cleaned by the aforementioned cleaning method, the distribution of particles remaining on a cleaned surface and having a particle size of 100 nm or more and 1000 nm or less is 15 particles/$cm^2$ or less.

According to the method for cleaning a substrate, it is possible to more securely obtain a substrate having fewer particles that may cause connection failure in a surface (circuit-forming surface) of the substrate after cleaning.

## ADVANTAGEOUS EFFECTS OF INVENTION

The temporary adhesive composition of the present invention can provide fewer particles that may cause connection failure in a substrate surface (circuit-forming surface) after cleaning. In particular, it is possible to provide a temporary adhesive material composition characterized in that when the composition is passed through a filtration filter having a pore size of 100 nm or less, the number of particles remaining after the filtration and having a particle size of 100 nm or more and 1000 nm or less is 20 particles/ml or less; and provide a cleaning method characterized in that a distribution of particles remaining on a cleaned substrate surface and having a particle size of 100 nm or more and 1000 nm or less is 15 particles/$cm^2$ or less.

DESCRIPTION OF EMBODIMENTS

Hereinafter, the present invention will be described in detail. However, the present invention is not limited thereto. First, the temporary adhesive material composition of the present invention will be described.

[Temporary Adhesive Material Composition]

When a step of grinding the back surface of a substrate having a semiconductor circuit formed thereon is performed, for example, the substrate and a support are joined to each other via a temporary adhesive layer containing a temporary adhesive agent for a substrate. As the temporary adhesive agent for a substrate of the present invention, the following silicone-based adhesive agent is used.

The present invention is directed to a temporary adhesive material composition for detachably bonding a substrate and a support, containing: (A) an organopolysiloxane mixture that undergoes hydrosilylation reaction for crosslinking; (B) an organopolysiloxane that undergoes no hydrosilylation reaction; (C) a catalyst; and (D) an organic solvent, in which, when the temporary adhesive material composition is passed through a filtration filter having a pore size of 100 nm or less, the number of particles remaining after the filtration and having a particle size of 100 nm or more and 1000 nm or less is 20 particles/ml or less.

The organopolysiloxane (A) that undergoes hydrosilylation reaction for crosslinking is a mixture. In this case, the mixture is preferably a mixture of different organopolysiloxanes (A-1) and (A-2).

It is preferable that component (A-1) is constituted of at least one of M unit represented by $R_1R_2R_3SiO_{1/2}$, D unit represented by $R_4R_5SiO_{2/2}$, T unit represented by $R_6SiO_{3/2}$ or Q unit represented by $SiO_{4/2}$, and substituents $R_1$, $R_2$, $R_3$, $R_4$, $R_5$, and $R_6$ are each a methyl group, $-CH=CH_2$ or a phenyl group; and component (A-2) is constituted of at least one of M unit represented by $R_7R_8R_9SiO_{1/2}$, D unit represented by $R_{10}R_{11}SiO_{2/2}$, T unit represented by $R_{12}SiO_{3/2}$ or Q unit represented by $SiO_{4/2}$, and substituents $R_7$, $R_8$, $R_9$, $R_{10}$, $R_{11}$, and $R_{12}$ are each a methyl group, a phenyl group or hydrogen.

More specifically, component (A-1) is an organopolysiloxane having 2 or more alkenyl groups per molecule. Examples of component (A-1) include a linear or branched diorganopolysiloxane having 2 or more alkenyl groups per molecule and an organopolysiloxane of a resin structure containing 2 or more alkenyl groups per molecule and a siloxane unit (Q unit) represented by $SiO_{4/2}$ unit. Component (A-1) preferably has an alkenyl-group content of 0.6 to 9 mole%. Note that, in the present invention, the alkenyl-group content refers to the ratio of a siloxane unit containing an alkenyl group among all siloxane units.

Such an organopolysiloxane is more specifically represented by the following formula (1), (2) or (3). The organopolysiloxane may be used alone, or used in combination of two or more.

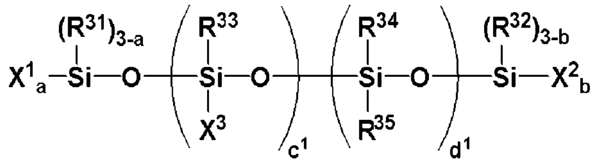

(1)

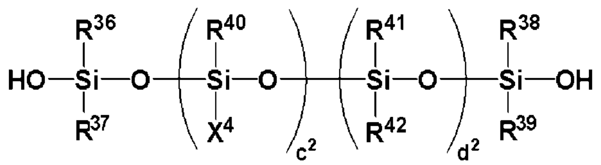

(2)

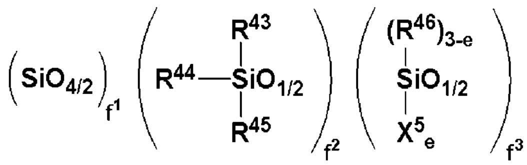

(3)

In formulae (1) to (3), $R^{31}$ to $R^{46}$ each independently represent a hydrocarbyl group having no aliphatic unsaturated bond; and $X^1$ to $X^5$ each independently represent a monovalent organic group containing an alkenyl group.

In formula (1), "a" and "b" each independently represent an integer of 0 to 3.

In formulae (1) and (2), $c^1$, $c^2$, $d^1$ and $d^2$ are integers satisfying $0 \le c^1 \le 10$, $2 \le c^2 \le 10$, $0 \le d^1 \le 100$ and $0 \le d^2 \le 100$, with the proviso that $a + b + c^1 \ge 2$. The values of a, b, $c^1$, $c^2$, $d^1$ and $d^2$ preferably satisfy a combination of numbers providing

an alkenyl-group content of 0.6 to 9 mole%.

In formula (3), "e" represents an integer of 1 to 3. The values of $f^1$, $f^2$ and $f^3$ satisfy $(f^2 + f^3)/f^1 = 0.3$ to 3.0 and, $f^3/(f^1 + f^2 + f^3) = 0.01$ to 0.6.

The hydrocarbyl group having no aliphatic unsaturated bonds is preferably one having 1 to 10 carbon atoms. Examples of the hydrocarbyl group include alkyl groups having 1 to 10 carbon atoms such as a methyl group, an ethyl group, a propyl group, and a butyl group; cycloalkyl groups having 4 to 10 carbon atoms such as cyclohexyl group; and aryl groups having 6 to 10 carbon atoms such as a phenyl group and a tolyl group. Of these, a methyl group or a phenyl group is preferable.

The monovalent organic group containing an alkenyl group preferably has 2 to 10 carbon atoms. Examples of the monovalent organic group include alkenyl groups having 2 to 10 carbon atoms such as a vinyl group, an allyl group, a hexenyl group, and an octenyl group; (meth)acryloylalkyl groups having 3 to 10 carbon atoms such as an acryloylpropyl group, an acryloylmethyl group, and a methacryloylpropyl group; (meth)acryloxyalkyl groups having 3 to 10 carbon atoms such as an acryloxypropyl group, an acryloxymethyl group, a methacryloxypropyl group, and a methacryloxymethyl group; a cyclohexenylethyl group, and a vinyloxypropyl group. Of these, a vinyl group is preferable in the industrial point of view.

In formula (1), when "a" and "b" are 1 to 3, molecular-chain terminal is capped with an alkenyl group. This case is preferable because a reaction can be completed in a shorter time with a highly reactive molecular-chain terminal alkenyl group. It is preferable that "a" and "b" are both 1 in consideration of an industrial aspect and cost. The alkenyl group-containing organopolysiloxane represented by formula (A-1) preferably has oil-like or raw rubber-like properties and further preferably oil-like properties, in view of filterability.

The compound represented by formula (3) is organopolysiloxane having a resin structure (three-dimensional mesh structure). In formula (3), "e" is preferably 1 in consideration of an industrial aspect and cost. A product of average value of "e" and $f^3/(f^1 + f^2 + f^3)$ is preferably 0.02 to 1.5, and more preferably, 0.03 to 1.0. An organopolysiloxane represented by formula (3) may be dissolved in an organic solvent and put to use.

A component (A-2) is a crosslinking agent, i.e., an organohydrogen polysiloxane containing at least two, preferably three or more, silicon atom-bonded hydrogen atoms (Si-H groups) in one molecule. The organohydrogen polysiloxane may be linear, branched, or cyclic. The organohydrogen polysiloxane may be used alone, or used in combination of two or more.

The viscosity of component (A-2) at 25°C is preferably 1 to 5000 mPa·s, and more preferably 5 to 500 mPa·s. Note that, in the present invention, viscosity is a measurement value obtained by a rotational viscometer at 25°C.

Component (A-2) is blended such that the total of the Si-H groups in component (A-2) based on the total of alkenyl groups in component (A-1), that is, the molar ratio (Si-H group/alkenyl group), falls within a range of preferably 0.3 to 10, and more preferably 1.0 to 8.0. If the molar ratio is 0.3 or more, the crosslink density does not excessively decrease, and the uncured composition layer can be sufficiently cured. If the molar ratio is 10 or less, the crosslink density does not excessively increase, and sufficient adhesive force and tack can be obtained. If the molar ratio is 10 or less, the available time of the temporary adhesive material composition can be extended.

The organopolysiloxane (B) that undergoes no hydrosilylation reaction is constituted of at least one of M unit represented by $R_{13}R_{14}R_{15}SiO_{1/2}$, D unit represented by $R_{16}R_{17}SiO_{2/2}$, T unit represented by $R_{18}SiO_{3/2}$ or Q unit represented by $SiO_{4/2}$. The functional group bound to silicon is preferably a hydrocarbyl group having 1 to 10 carbon atoms. Examples of the hydrocarbyl group include, alkyl groups having 1 to 10 carbon atoms such as a methyl group, an ethyl group, a propyl group, and a butyl group; cycloalkyl groups having 4 to 10 carbon atoms such as a cyclohexyl group; aryl groups having 6 to 10 carbon atoms such as a phenyl group and a tolyl group. Of these, a methyl group or a phenyl group is preferable. More specifically, the above substituents $R_{13}$, $R_{14}$, $R_{15}$, $R_{16}$, $R_{17}$, and $R_{18}$ are each preferably a methyl group or a phenyl group. The organopolysiloxane may be a single compound or a mixture of two or more.

The component (B) is preferably added to the organopolysiloxane mixture (A) that undergoes crosslinking by the hydrosilylation reaction in a ratio of 0.1 to 80 mass%, but the ratio is not particularly limited.

As component (C) as a catalyst, a platinum catalyst (more specifically, a platinum-group metal catalyst) is suitably used. Examples of the platinum catalyst include chloroplatinic acid, an alcohol solution of chloroplatinic acid, a reaction product of chloroplatinic acid and an alcohol, a reaction product of chloroplatinic acid and an olefin compound, and a reaction product of chloroplatinic acid and a vinyl group-containing siloxane. The platinum catalyst may be used alone, or used in combination of two or more.

Component (C) as a catalyst is blended in an amount of preferably 1 to 5000 ppm, and more preferably 5 to 2000 ppm in terms of platinum-group metal content (mass conversion) based on the total of components (A-1) and (A-2). If the content is 1 ppm or more, the curability of the uncured composition layer rarely decreases, so that a reduction of crosslink density and a reduction of retentivity can be suppressed. If the content is 5,000 ppm or less, the available time of the temporary adhesive material composition can be extended.

As organic solvent (D), a saturated hydrocarbon having 8 to 12 carbon atoms containing no heteroatoms can be suitably used. Examples of the saturated hydrocarbon include hydrocarbon solvents such as pentane, hexane, cyclohexane, isooctane, nonane, decane, p-menthane, pinene, isododecane, and limonene, and silicone solvents. The organic

solvent is not particularly limited as long as it can dissolve the components of the temporary adhesive material composition.

The content of the organic solvent in the temporary adhesive material composition is preferably 10 to 900 parts by mass, more preferably 25 to 400 parts by mass, and further preferably 40 to 300 parts by mass, based on the total (100 parts by mass) of components (A-1) and (A-2). The organic solvent may be used alone, or used in combination of two or more.

The temporary adhesive material composition may contain a reaction control agent. The reaction control agent refers to an agent that is optionally added, if necessary, for suppressing thickening and gelling of an uncured composition before thermal curing when the uncured composition is prepared or applied to a base material.

Examples of the reaction control agent include 3-methyl-1-butyn-3-ol, 3-methyl-1-pentyn-3-ol, 3,5-dimethyl-1-hexyn-3-ol, 1-ethynylcyclohexanol, 3-methyl-3-trimethylsiloxy-1-butyne, 3-methyl-3-trimethylsiloxy-1-pentyne, 3,5-dimethyl-3-trimethylsiloxy-1-hexyne, 1-ethynyl-1-trimethylsiloxycyclohexane, bis(2,2-dimethyl-3-butynyloxy)dimethylsilane, 1,3,5,7-tetramethyl-1,3,5,7-tetravinylcyclotetrasiloxane, and 1,1,3,3-tetramethyl-1,3-divinyldisiloxane. Of these, 1-ethynylcyclohexanol and 3-methyl-1-butyn-3-ol are preferable.

In a case where the temporary adhesive material composition contains a reaction control agent as mentioned above, the content of the reaction control agent is preferably 0.01 to 8.0 parts by mass, and more preferably 0.05 to 2.0 parts by mass, based on the total (100 parts by mass) of components (A-1) and (A-2). If the content is 0.01 parts by mass or more, the effect of the reaction control agent is sufficiently exhibited. If the content is 8.0 parts by mass or less, the curability of an uncured composition layer rarely decreases. The reaction control agent may be used alone, or used in combination of two or more.

The temporary adhesive material composition may further contain an additional component. Examples of the additional component include a filler such as silica; a non-reactive organopolysiloxane such as polydimethylsiloxane and polydimethyldiphenylsiloxane; an antioxidant such as phenol-based, quinone-based, amine-based, phosphorus-based, phosphite-based, sulfur-based, and thioether-based antioxidants; a light stabilizer such as a triazole-based, and benzophenone-based light stabilizer; a flame retardant such as phosphate-based, halogen-based, phosphite-based, and antimony-based flame retardant; and an antistatic agent such as a cationic surfactant, an anionic surfactant, and a nonionic surfactant. The additional component may be used alone, or used in combination of two or more.

In a case where the temporary adhesive material composition contains other components, the components each may be blended in an appropriate range. For example, if a filler is used for enhancing heat resistance, the content thereof is preferably 50 parts by mass or less based on the total (100 parts by mass) of components (A-1) and (A-2).

The temporary adhesive material composition of the present invention has a formulation as mentioned above. It is characterized in that when the temporary adhesive material composition is passed through a filtration filter having a pore size of 100 nm or less, the number of particles remaining after the filtration and having a particle size of 100 nm or more and 1000 nm or less is 20 particles/ml or less. The number of particles mentioned above can be achieved, for example, by filtration of the temporary adhesive material composition.

[Filtration of Temporary Adhesive Material Composition]

Before the temporary adhesive material composition is applied to a substrate, insoluble impurities such as gel-like fine particles or solid fine particles in the composition are removed. Examples of the method for removing these insoluble impurities include a method of passing impurities through a filtration filter.

Examples of the filtration filter for temporary adhesive material composition include, but are not particularly limited to, filters formed of a fluororesin such as polytetrafluoroethylene and polyvinylidene fluoride; a polyolefin resin such as polyethylene and polypropylene; and a polyamide resin such as nylon 66. In view of stability and elution of the filter, a fluororesin filter is suitably used.

Examples of the shape of the filtration filter include, but are not particularly limited to, a funnel shape, a disc shape and a cartridge shape. As the material for portions except the filter portion, a fluororesin is suitably used in view of stability and elution.

It is required that the pore size of the filtration filter is large enough to remove the smallest possible insoluble impurities contained in a highly viscous temporary adhesive material composition. Although the lower limit is not particularly limited, the pore size of the filter to be used is preferably 0.5 nm or more, more preferably 1 to 100 nm, and further preferably 10 to 70 nm.

The filtration rate is not limited as long as a temporary adhesive material can pass through at the filtration rate, but is preferably 10 ml/minute or more, more preferably 30 ml/minute or more, and further preferably, 50 ml/minute or more.

The number of particles to be contained in the temporary adhesive material composition passed through a filtration filter is as follows: The number of particles having a particle size of 100 nm or more is 20 particles/ml or less, more preferably 10 particles/ml or less, further preferably, 3.0 particles/ml or less, and most preferably 0 particles/ml.

[Previous Stage of Method for Cleaning Substrate of the Present Invention]

The method for cleaning a substrate of the present invention is characterized by a method for cleaning a substrate, including: the steps of attaching an adhesive sheet so as to entirely cover a temporary adhesive material composition on a substrate and detaching the adhesive sheet, thereby removing the temporary adhesive material composition; cleaning the substrate with cleaning solution A; rinsing the substrate with cleaning solution B; and rinsing the substrate with cleaning solution C. First, a substrate to be subjected to cleaning and a process for obtaining the substrate will be described.

[Step (a)]

As mentioned above, in a case where a step of grinding the back surface of a substrate having a semiconductor circuit formed thereon is performed, for example, the substrate and a support are joined to each other via a temporary adhesive layer containing a temporary adhesive agent for a substrate. In the method for cleaning a substrate of the present invention, before a substrate and a support are bonded to each other with a temporary adhesive agent, first treatment by a filtration method as mentioned above is preferably performed.

[Method for Preparing Laminate]

The temporary adhesive material composition is used in producing a thin wafer, more specifically, in forming a laminate by laminating a substrate to a support via the temporary adhesive material composition such that the front surface having a circuit formed thereon faces the support. A process for reducing thickness of a substrate is performed, for example, by a method having step (b) of forming a substrate laminate, step (c) of grinding or polishing the back surface of the substrate of the substrate laminate, step (d) of applying processing to the back surface of the substrate, and step (e) of detaching the support from the substrate laminate.

[Step (b)]

In step (b), more specifically, a substrate, which has a circuit-forming surface on the front surface and no circuit-forming surface on the back surface, is joined to a support via a temporary adhesive layer (hereinafter, referred to as cured layer ($\alpha$)) such that the circuit-forming surface faces the support. The cured layer ($\alpha$) is not particularly limited, but preferably a layer obtained by thermally curing a silicone-based adhesive agent, such as an uncured composition of a thermosetting organopolysiloxane or a thermoplastic organopolysiloxane, and particularly preferably a layer obtained by thermally curing a temporary adhesive material composition passed through a filtration filter in view of reducing the number of particles after cleaning. Step (b), more specifically, includes step (b-1) of laminating the temporary adhesive material composition serving as a silicone-based adhesive agent on a support; step (b-2) of laminating a substrate having a circuit-forming surface on the front surface and having no circuit-forming surface on the back surface to a support via the temporary adhesive material composition layer such that the front surface having a circuit-forming surface on the substrate faces the temporary adhesive material composition layer; and step (b-3) of thermally curing the temporary adhesive material composition layer to obtain a cured layer ($\alpha$). Alternatively, step (b) includes step (b-1') of laminating the temporary adhesive material composition layer on a circuit-forming surface of a substrate, which has a circuit-forming surface on the front surface and no circuit-forming surface on the back surface; step (b-2) of laminating the substrate to a support via the temporary adhesive material composition layer; and step (b-3) of thermally curing the temporary adhesive material composition layer to obtain a cured layer ($\alpha$).

In step (b-1) or (b-1'), when the adhesive material composition layer is laminated, a film formed of the adhesive material composition may be used. Alternatively, a solution of the adhesive material composition may be laminated by a method such as spin-coating, slit-coating or spray-coating, and preferably, laminated by spin-coating. In this case, usually after the spin-coating, pre-baking is performed at a temperature of preferably 80 to 250°C, and more preferably 100 to 230°C depending on the volatilization conditions of a solvent contained in the adhesive material composition.

In step (b-1) or (b-1'), it is preferable that the adhesive material composition layer is formed so as to have a film thickness of 10 to 150 μm. If the film thickness is 10 μm or more, it is possible to laminate a substrate to a support without any gaps and the adhesive material composition layer is sufficiently durable to the grinding step described later. If the film thickness is 150 μm or less, it is possible to suppress deformation of a resin in the heat treatment step such as TSV formation step described later and the adhesive material composition layer can be enough to be put in practical use.

In step (b-2) or (b-2'), a method for laminating a substrate to a support is, for example, a method of subjecting a substrate to uniform pressure bonding performed under reduced pressure at preferably 40 to 250°C, and more preferably 60 to 200°C. In the laminating, a commercially available wafer bonding apparatus such as EVG520IS 850TB (trade name) manufactured by EVG, XBC300 (trade name) manufactured by SUSS, or Synapse V (trade name) manufactured by Tokyo

Electron Ltd., is used.

In step (b-3), an uncured composition layer is cured by heating the uncured composition layer, for example, at preferably 120 to 250°C, and more preferably 140 to 200°C for preferably 10 minutes or more and 4 hours or less, and more preferably 30 minutes or more and 2 hours or less.

The substrate to be used in step (b) is usually a semiconductor wafer. Examples of the semiconductor wafer include a silicon wafer, a germanium wafer, a gallium-arsenic wafer, a gallium-phosphorus wafer, and a gallium-arsenic-aluminum wafer. The thickness of the wafer is not particularly limited but typically 600 to 800 μm, and more typically 625 to 775 μm.

Examples of the support to be used in step (b) include substrates such as a silicon wafer, a glass plate and a quartz wafer.

[Temporary Adhesive Layer (Cured Layer (α))]

The cured layer (α) is obtained by thermally curing the temporary adhesive material composition layer, as previously mentioned.

The cured layer (α) laminated on a support is interfacially peeled from the support at a peel force of preferably 10 to 500 mN/25 mm, more preferably 30 to 500 mN/25 mm, and further preferably 50 to 200 mN/25 mm. The peel force herein is a peel force obtained by a 180° peel test in which a 25 mm-width test piece is peeled up at 5 mm/second. If the amount of peeling is 10 mN/25 mm or more, it is possible to suppress peeling during e.g., processing step described later, whereas if the amount of peeling is 500 mN/25 mm or less, the cured layer (α) can be easily detached from a support.

In the case of the cured layer (α) laminated on a substrate a peel force required for interfacially peeling it from the substrate is preferably 50 to 1000 mN/25 mm, more preferably 70 to 1000 mN/25 mm, and further preferably 80 to 500 mN/25 mm or less. The peel force herein is a peel force obtained by a 180° peel test in which a 25 mm-width test piece is peeled up at 5 mm/second. If the amount of peeling is 50 mN/25 mm or more, peeling can be suppressed during, e.g., processing step described later, and peeling rarely occurs even if the cured layer (α) is subjected to, in particular, a high-temperature process, whereas if the amount of peeling is 1000 mN/25 mm or less, the cured layer (α) can be detached from a support by a tape.

The cured layer (α) preferably has a storage modulus of $1 \times 10^6$ to $1 \times 10^9$ Pa at 25°C. If the storage modulus falls within the range, the cured layer (α) is sufficiently durable to the grinding step described later and the warping of the substrate can be reduced. Because of this, a problem of failing to fit to an apparatus rarely occurs in a step.

[Step (c)]

Step (c) is a step of grinding or polishing the back surface of a substrate of a substrate laminate. In step (c), the thickness of the substrate is reduced by grinding or polishing the back surface (non-circuit-forming surface) of the substrate joined to a support. The thickness of the substrate reduced in thickness is typically 5 to 300 μm, and preferably 10 to 100 μm. A grinding-processing method is not particularly limited and can be performed in a manner known in the technical field. The grinding is preferably performed by pouring water onto a substrate and a grinding stone (e.g., diamond) while cooling. Examples of an apparatus for use in grinding-processing the back surface of a substrate include DAG-810 (trade name) manufactured by Disco. The back surface of a substrate may be processed by chemical mechanical polishing (CMP).

[Step (d)]

Step (d) is a step of processing the back surface of a substrate. In step (d), the back surface of a substrate (non-circuit-forming surface) reduced in thickness by back-surface grinding or back-surface polishing in step (c) is processed. In this step, various processes that are applied to a wafer are included. Examples of the processes include electrode formation, metal wiring formation, and protective film formation, and more specifically, include conventionally known processes such as metal sputtering for forming an electrode, wet etching for etching a metal sputtering layer, application of a resist used as a mask during metal wiring formation, formation of pattern by light exposure and development, detachment of a resist, dry etching, metal plating, silicon etching for forming TSV, and formation of an oxide film on a silicon surface. Cutting a wafer reduced in thickness into chip-size pieces, by, e.g., dicing, is also included.

[Step (e)]

Step (e) is a step of detaching a support from a substrate laminate. In step (e), a support is detached from a substrate laminate processed in step (d). The detachment step is performed, generally at a relatively low temperature within the range of room temperature to about 60°C. Detachment can be made by horizontally fixing one of the substrate

and the support of a substrate laminate and lifting up the other one at a predetermined angle with respect to the horizontal direction. Alternatively, a protective film is attached to the grinding surface on a substrate, and the substrate with the protective film may be detached by a peeling method.

The peeling method includes step (e-1) of bonding a dicing tape to the processed surface of a substrate, step (e-2) of vacuum-suctioning a dicing-tape surface onto an adsorption surface and step (e-3) of detaching the support from the substrate by a peel-off method at an adsorption-surface temperature within a range of 10°C or more and 100°C or less. In this case, the support can be easily detached from the substrate and a dicing step (described later) can be easily performed.

In such a detachment step, a cured layer (α) is detached from a substrate laminate together with a support to obtain a substrate alone. Alternatively, a support alone is detached from a substrate laminate to obtain a substrate having a cured layer (α) laminated thereon can be obtained. The latter case, as in step (f) (described later), a step of detaching a cured layer (α) from a substrate, for example, by tape peeling is performed to obtain the substrate alone.

[Method For Cleaning Substrate]

The method for cleaning a substrate is used, for example, in cleaning a substrate during thin-wafer production. In other words, it is a process of detaching the support from a substrate laminate, which has the support, a temporary adhesive layer formed on the support, and a substrate such that a front surface having a circuit formed thereon faces the temporary adhesive layer, thereby removing the temporary adhesive layer remaining on the substrate.

The temporary adhesive material remaining on the substrate is removed, for example, by a method including step (f) of attaching an adhesive sheet so as to entirely cover a temporary adhesive layer on a substrate and detaching the adhesive sheet to remove the temporary adhesive layer, step (g) of cleaning the substrate with cleaning solution A, step (h) of cleaning the substrate with cleaning solution B, and step (i) of cleaning the substrate with cleaning solution C.

[Step (f)]

The step (f) is a step of removing the temporary adhesive layer remaining on a substrate by tape peeling. An adhesive sheet is attached so as to entirely cover a temporary adhesive layer on a substrate and the adhesive sheet is detached, thereby removing the temporary adhesive layer to obtain the substrate alone. The tape material for use in tape peeling is preferably a tape using a silicone adhesive material. For example, a polyester film adhesive tape No. 646S, or No.648 manufactured by Teraoka Seisakusho Co., Ltd. is suitably used.

[Step (g)]

Step (g) is a step of cleaning the surface of a substrate with cleaning solution A. In step (g), the surface (circuit-forming surface) of a substrate is cleaned with cleaning solution A to remove the remaining cured layer (α) (cured product of an uncured composition). In this manner, the cured layer (α) partly remaining on the surface of the substrate even after a support and a cured layer (α) are detached in step (e), can be sufficiently removed.

Cleaning can be made by soaking a substrate in cleaning solution A. The soaking time is preferably 10 seconds or more and 30 minutes or less, and more preferably 30 seconds or more and 10 minutes or less. Cleaning may be made by spraying cleaning solution A onto a substrate. Furthermore, cleaning can be made by paddling, shaking, or ultrasonic cleaning with cleaning solution A. The temperature for cleaning is preferably 10 to 50°C, and more preferably, 20 to 40°C.

Cleaning solution A is not particularly limited as long as it dissolves a cured layer (α) of the temporary adhesive material composition. Examples of cleaning solution A include aliphatic hydrocarbon compounds such as pentane, hexane, cyclohexane, decane, isododecane, and limonene; aromatic hydrocarbon compounds such as benzene, toluene, xylene, and mesitylene; and heteroatom containing compounds such as N,N-dimethylformamide, N,N-dimethylacetamide, N,N-dimethylpropionamide and N-methylpyrrolidone. The solvent may be used alone, or used in combination of two or more. In a hard-to-remove case, a base or an acid may be added to a solvent as mentioned above. Examples of the base that can be used include amines such as ethanolamine, diethanolamine, triethanolamine, triethylamine, and ammonia, and ammonium salts such as tetramethylammonium hydroxide. Examples of the acid that can be used include organic acids such as acetic acid, oxalic acid, benzenesulfonic acid, and dodecylbenzenesulfonic acid. The amount to be added is 0.01 to 10 mass%, and preferably 0.1 to 5 mass% in terms of concentration in a cleaning solution. Cleaning solution A is particularly preferably a cleaning solution containing a quaternary ammonium salt. The quaternary ammonium salt is a compound represented by $R_AR_BR_CR_DN^+X^-$, and $R_A$ to $R_D$ is each independently selected from, e.g., an alkyl group, an aryl group and an aralkyl group. $X^-$ is selected from a fluoride ion or a hydroxide ion.

[Step (h)]

Step (h) is a step of rinsing the surface of a substrate with cleaning solution B. In step (h), a surface (circuit-forming surface) of a substrate is rinsed with cleaning solution B to remove cleaning residues and cleaning solution A.
Cleaning solution B is not particularly limited as long as it can dissolve the cured layer ($\alpha$) of the temporary adhesive material composition and cleaning solution A. Examples of cleaning solution B include a cleaning solution of a compound such as pentane, hexane, cyclohexane, decane, isododecane, and limonene. Particularly, in a case where an ammonium salt is used as an additive of cleaning solution A, a water-soluble organic solvent is preferably used. Examples of the water-soluble organic solvent include methanol, ethanol, 1-propanol, and 2-propanol. The solvent may be used alone, or used in combination of two or more.
As rinsing with cleaning solution B, it is preferable to use a method of pouring cleaning solution B onto a substrate while horizontally holding and rotating the substrate at a constant speed. The solution may be poured onto only the center of a substrate or in a manner of reciprocally moving the center and the outer circumference. The rotation speed of a substrate is not particularly limited but is preferably 1 to 500 rpm, and more preferably, 200 to 300 rpm. The flow rate is not particularly limited but is preferably 1 to 100 mL/second, and more preferably 10 to 30 mL/second. The temperature of cleaning solution B is preferably 10 to 50°C, and more preferably 20 to 40°C.

[Step (i)]

Step (i) is a step of rinsing a surface of a substrate with cleaning solution C. In step (i), the surface (circuit-forming surface) of a substrate is rinsed with cleaning solution C to remove cleaning residues and cleaning solution B.
As cleaning solution C, water is preferably used, more preferably pure water is used, and most preferably ultrapure water is used.
As rinsing with cleaning solution C, it is preferable to use a method of pouring cleaning solution C onto a substrate while horizontally holding and rotating the substrate at a constant speed. The solution may be poured onto only the center of a substrate or in a manner of reciprocally moving the center and the outer circumference. The rotation speed of the substrate is not particularly limited, but preferably 1 to 500 rpm, and more preferably, 200 to 300 rpm. The flow rate is not particularly limited but is preferably 1 to 100 mL/second, and more preferably 10 to 30 mL/second. The temperature of cleaning solution B is preferably 10 to 50°C, and more preferably 20 to 40°C.
To reduce the distribution number of residual particles after cleaning, the above cleaning solutions A, B, and C are preferably passed through a filtration filter, in advance. The number of particles contained in a cleaning solution passed through a filtration filter are as follows: The number of particles having a particle size of 100 nm or more is further preferably 3.0 particles/ml or less, and most preferably 2 particles/ml or less or 1 particle/ml or less, and most preferably 0 particle/ml. The distribution number of residual particles after cleaning is preferably 15 particles/$cm^2$ or less. The lower limit is not particularly limited, but is about 0.5 particles/$cm^2$.
The substrate after cleaning may be dried with air blow or spin dry.

EXAMPLE

Now, the present invention will be more specifically described by way of Examples below, but the present invention is not limited to the following Examples. [1] The residual particles contained in temporary adhesive material composition and [2] the particles after cleaning of a substrate will be described. Note that, in order to measure particles after cleaning on a substrate, a silicon wafer (mirror surface) having no circuit-forming surface was used as the substrate. To prevent contamination with particles except those derived from the temporary adhesive material composition and the cleaning step, step (c) (step of grinding or polishing the back surface of a substrate of a substrate laminate) and step (d) (step of processing the back surface of the substrate) were skipped. Note that, in the following examples, a molecular weight refers to a weight average molecular weight (Mw), which is a polystyrene equivalent value obtained by GPC using toluene as a solvent. The filtration rate can be obtained from m/(d*t) wherein d [g/ml] represents specific gravity of a temporary adhesive material composition for a substrate, m [g] represents the weight of the composition obtained by filtration and t [minutes] represents time required for filtration.

[1] Residual Particles Contained in Temporary Adhesive Material Composition

<Preparation of Temporary Adhesive Material Composition for Substrate>

(Step [a])

[Example 1-1]

To a solution consisting of 100 parts by mass of a linear polydimethylsiloxane (molecular weight: 50,000, manufactured by Shin-Etsu Chemical Co., Ltd.) having 98.0 mole% of $(CH_3)_2SiO_{2/2}$ unit (D unit) and 2.0 mole% of $(CH_2=CH)(CH_3)SiO_{2/2}$ unit ($D^{Vi}$ unit) having a vinyl group at a molecular side chain as the organopolysiloxane (A-1), and 100 parts by mass of isododecane, an organohydrogen polysiloxane (50 parts by mass) represented by the following (M-1) as the organopolysiloxane (A-2), 30 parts by mass of a linear polydimethylsiloxane (molecular weight: 80,000, manufactured by Shin-Etsu Chemical Co., Ltd.) as the organopolysiloxane (B), and 0.7 parts by mass of ethynylcyclohexanol were added. After the mixture was sufficiently mixed, 0.2 parts by mass of platinum catalyst CAT-PL-5 (manufactured by Shin-Etsu Chemical Co., Ltd.) was added. The resultant mixture was further sufficiently mixed. Note that, in the resin solution, the molar ratio of an Si-H group of an organohydrogen polysiloxane having an Si-H group relative to alkenyl group of an organopolysiloxane having an alkenyl group was 1.0. Subsequently, the mixture solution was filtered by a filtration filter (capsule filter, manufactured by Pall Corporation) having a pore size of 30 nm to obtain temporary adhesive material composition N. The filtration was carried out at room temperature and a filtration pressure of 0.1 MPa.

Note that, in Example 1, the molar ratio (Si-H/Si-Vi) of the Si-H group of the organohydrogen polysiloxane having an Si-H group relative to the alkenyl group of the organopolysiloxane having an alkenyl group was calculated in accordance with the following formula (wherein, PDMS: organopolysiloxane, POHS: organohydrogen polysiloxane).

(1) Amount of Si-Vi (mole) from (A-1) component

(PDMS addition amount/PDMS molecular weight) × {PDMS molecular weight/(D unit molecular weight × D unit mole %/100 + $D^{Vi}$ unit molecular weight × D unit mole%/100)} × $D^{Vi}$ unit mole%/100

(2) Amount of Si-H (mole) from (A-2) component

(POHS addition amount/POHS molecular weight) × the number of siloxane units to which H is bound per molecule

(3) Value of Si-H/Si-Vi

Amount of Si-H (mole) from (A-2) component/amount of Si-Vi (mole) from (A-1) component

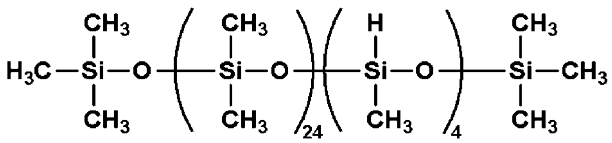

(M-1)

[Example 1-2]

Temporary adhesive material composition M was obtained in the same manner as Example 1-1 except that the mixture solution was filtered by a filtration filter (PTFE capsule filter, manufactured by Toyo Roshi Kaisha, Ltd.) having a pore size of 50 nm.

[Example 1-3]

Temporary adhesive material composition O was obtained in the same manner as Example 1-1 except that the mixture solution was filtered by a filtration filter (PTFE capsule filter, manufactured by Toyo Roshi Kaisha, Ltd.) having a pore size of 100 nm.

[Example 1-4]

To a solution consisting of 100 parts by mass of a linear polydimethylsiloxane (molecular weight: 30,000,

manufactured by Shin-Etsu Chemical Co., Ltd.) having 97.5 mole% of $(CH_3)_2SiO_{2/2}$ unit (D unit) as organopolysiloxane (A-1), and 2.5 mole% $(CH_2=CH)(CH_3)SiO_{2/2}$ unit ($D^{Vi}$ unit) having a vinyl group at a molecular side chain and 100 parts by mass of isododecane, 2 parts by mass of an organohydrogen polysiloxane represented by the following (M-2) as the organopolysiloxane (A-2), 30 parts by mass of a linear polydimethylsiloxane (molecular weight: 50,000, manufactured by Shin-Etsu Chemical Co., Ltd.) as the organopolysiloxane (B), and 0.7 parts by mass of ethynylcyclohexanol were added. After the mixture was sufficiently mixed, 0.2 parts by mass of a platinum catalyst, CAT-PL-5 (manufactured by Shin-Etsu Chemical Co., Ltd.) was added. The resultant mixture was further sufficiently mixed. Note that, in the resin solution, the molar ratio of an Si-H group of an organohydrogen polysiloxane having an Si-H group relative to alkenyl group of an organopolysiloxane having an alkenyl group was 1.1. Subsequently, the mixture solution was filtered by a filtration filter (PTFE capsule filter manufactured by Toyo Roshi Kaisha, Ltd.) having a pore size of 50 nm to obtain temporary adhesive material composition P.

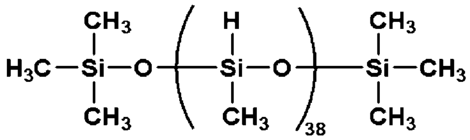

(M-2)

[Example 1-5]

Temporary adhesive material composition Q was obtained in the same manner as Example 1-3 except that the mixture solution was filtered by a filtration filter (PTFE capsule filter, manufactured by Toyo Roshi Kaisha, Ltd.) having a pore size of 100 nm.

[Example 1-6]

Preparation of a substrate laminate and cleaning of a substrate were performed in the same manner as in Example 1-1 except that the temporary adhesive material composition shown below was used. To a solution consisting of 100 parts by mass of a linear polydimethylsiloxane (molecular weight: 50,000, manufactured by Shin-Etsu Chemical Co., Ltd.) having 97.0 mole% of $(CH_3)_2SiO_{2/2}$ unit (D unit), and 3.0 mole% of $(CH_2=CH)(CH_3)SiO_{2/2}$ unit ($D^{Vi}$ unit) having a vinyl group at a molecular side chain as the organopolysiloxane (A-1) and 100 parts by mass of isododecane, an organohydrogen polysiloxane (5.5 parts by mass) represented by the following (M-3) as the organopolysiloxane (A-2), 30 parts by mass of a linear polydimethylsiloxane (molecular weight: 100,000, manufactured by Shin-Etsu Chemical Co., Ltd.) as the organopolysiloxane (B), and 0.7 parts by mass of ethynylcyclohexanol were added. After the mixture was sufficiently mixed, 0.2 parts by mass of platinum catalyst CAT-PL-5 (manufactured by Shin-Etsu Chemical Co., Ltd.) was added. The resultant mixture was further sufficiently mixed. Note that, in the resin solution, the molar ratio of an Si-H group of an organohydrogen polysiloxane having an Si-H group relative to alkenyl group of an organopolysiloxane having an alkenyl group was 1.1. Subsequently, the mixture solution was filtered by a filtration filter (PTFE capsule filter manufactured by Toyo Roshi Kaisha, Ltd.) having a pore size of 50 nm to obtain temporary adhesive material composition R.

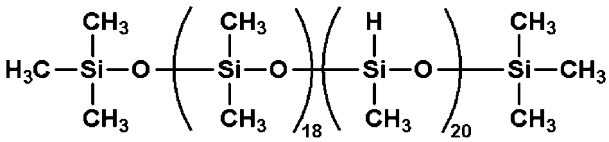

(M-3)

[Comparative Example 1-1]

Temporary adhesive material composition S was obtained in the same manner as Example 1-1 except that the mixture solution was filtered by a filtration filter (PTFE membrane filter, manufactured by Toyo Roshi Kaisha, Ltd.) having a pore size of 200 nm.

[Comparative Example 1-2]

Temporary adhesive material composition T was obtained in the same manner as Example 1-3 except that the mixture solution was filtered by a filtration filter (PTFE membrane filter, manufactured by Toyo Roshi Kaisha, Ltd.) having a pore size of 200 nm.

[Comparative Example 1-3]

Temporary adhesive material composition U was obtained in the same manner as Example 1-5 except that the mixture solution was filtered by a filtration filter (PTFE membrane filter, manufactured by Toyo Roshi Kaisha, Ltd.) having a pore size of 200 nm.

<Evaluation of Particles Remaining after Filtration>

The temporary adhesive material compositions of Examples 1-1 to 1-6, and Comparative Examples 1-1 to 1-3 were filtered by filters different in pore size and then the numbers of remaining particles having a particle size of 100 nm or more and 1000 nm or less (average of 5 samples) were measured. If the number of the remaining particles is 20 particles/ml or less, the temporary adhesive material composition is evaluated as excellent because the number of particles to be introduced to a substrate is low. Note that, measurement was performed by use of a particle counter (trade name: KS-42A, RION Co., Ltd.).

[Table 1]

| | Temporary adhesive material composition | Filtration filter pore-size [nm] | Average filtration rate [ml/minute] | Number of remaining particles [particles/ml] |
|---|---|---|---|---|
| Example 1-1 | N | 30 | 10 | 4.6 |
| Example 1-2 | M | 50 | 18 | 6.7 |
| Example 1-3 | O | 100 | 25 | 17.2 |
| Example 1-4 | P | 50 | 20 | 7.8 |
| Example 1-5 | Q | 100 | 24 | 16.4 |
| Example 1-6 | R | 50 | 21 | 8.0 |
| Comparative Example 1-1 | S | 200 | 28 | 102.7 |
| Comparative Example 1-2 | T | 200 | 26 | 130.5 |
| Comparative Example 1-3 | U | 200 | 29 | 111.9 |

As listed in Table 1, the numbers of particles having a particle size of 100 nm or more and 1000 nm or less and contained in the temporary adhesive material compositions of Examples 1-1 to 1-6 passed through a filtration filter having a pore size of 100 nm or less were all 20 particles/ml or less. In contrast, Comparative Examples 1-1 to 1-3 are temporary adhesive material compositions passed through a filtration filter having a pore size of 200 nm and the numbers of particles having a particle size of 100 nm or more and 1000 nm or less contained were all more than 20 particles/ml. Thus, the temporary adhesive material composition of the present invention is determined as a temporary adhesive material composition that introduces few particles to a substrate.

[2] Particles after Cleaning of Substrate

[Examples 2-1]

A substrate laminate using temporary adhesive material composition N was formed. Temporary adhesive material composition N was applied onto a substrate in accordance with the aforementioned method. When the peel force of the cured layer ($\alpha$) obtained by thermal curing was measured at room temperature in accordance with JIS K 6854, it was 98 mN/25 mm. The storage modulus of the cured layer ($\alpha$) at 25°C was $2.9 \times 10^7$ Pa. Note that, the storage modulus of a cured product was measured by Rheogel-E4000 manufactured by UBM at a frequency of 1 Hz and 25°C.

<Preparation of Substrate Laminate>

On a 300-mm silicon wafer (mirror surface, thickness: 725 $\mu$m) used as a substrate, the temporary adhesive material composition prepared above was applied by spin-coating. The wafer was heated by a hot plate at 50°C for 3 minutes to form a temporary adhesive material composition layer (thickness: 25 $\mu$m). Subsequently, the wafer was joined to a 300-mm glass wafer (thickness: 700 $\mu$m) used as a support by wafer bonding apparatus (EVG520IS (trade name)

manufactured by EVG). The joining was performed at a joining temperature of 50°C, a chamber pressure of $10^{-3}$ mbar or less and a load of 10 kN during the joining. After completion of joining, the resultant substrate was heated in an oven at 200°C for 2 hours to cure temporary adhesive material composition layer, which was then cooled up to room temperature. In this manner, a substrate laminate was obtained.

<Detachment of Substrate Laminate>

(Step [e])

A support was detached from a substrate laminate. More specifically, dicing tape was attached to the laminate on a silicon wafer side using a dicing frame. The dicing-tape surface was set on an adsorption plate by vacuum adsorption. Thereafter, at room temperature, a glass wafer was detached by lifting a point of a glass wafer by tweezers.

<Cleaning Step of Substrate>

(Step [f])

The temporary adhesive material composition remaining on a substrate was detached by tape-peeling. More specifically, polyester-film adhesive tape No. 648 manufactured by Teraoka Seisakusho Co., Ltd. was attached to the temporary adhesive layer exposed on the surface and tape-peeling was performed. In this manner, the remaining temporary adhesive layer was detached from a silicon wafer substrate.

<Preparation of Cleaning Solution for Substrate>

To N,N-dimethylpropionamide, tetrabutylammonium fluoride was added. The mixture was stirred at room temperature to obtain cleaning solution A. Note that tetrabutylammonium fluoride was already dissolved in cleaning solution A. Herein, cleaning solution A was prepared such that 10 mass% of tetrabutylammonium fluoride was contained in 100 mass% of tetrabutylammonium fluoride and N,N-dimethylpropionamide. Cleaning solution A was filtered by a filtration filter having a pore size of 20 nm (PTFE capsule filter manufactured by Toyo Roshi Kaisha, Ltd.). The number of particles having a particle size of 100 nm or more and contained in cleaning solution A after filtration was 2.4 particles/ml.

Isopropanol was filtered by a filtration filter of 20 nm in pore size (cartridge filter manufactured by Entegris Inc.) to obtain cleaning solution B. The number of particles having a particle size of 100 nm or more contained in cleaning solution B after filtration was 0.7 particles/ml.

Purified ultrapure water purified by an ultrapure water purification apparatus (trade name: MILLIPURE Advantage 10 uv, manufactured by Merck KGaA) was filtered by a filtration filter having a pore size of 20 nm (capsule filter manufactured by Pall Corporation) to obtain cleaning solution C. The number of particles having a particle size of 100 nm or more contained in cleaning solution C after filtration was 1.1 particles/ml.

(Step [g])

A substrate was fixed to a wafer cleaning apparatus (trade name: Delta, manufactured by SUSS) and subjected to cleaning with a liquid. More specifically, the substrate was soaked in 300 ml of cleaning solution A at room temperature for 5 minutes, and thereafter cleaning solution A was poured onto the substrate for 10 seconds while rotating the substrate at 250 rpm to perform cleaning.

(Step [h])

Cleaning solution B was poured at a flow rate of 15 ml/second onto the substrate for 10 seconds while rotating the substrate at 250 rpm to perform cleaning.

(Step [i])

Cleaning solution C was poured at a flow rate of 15 ml/second onto the substrate for 10 seconds while rotating the substrate at 250 rpm to perform cleaning.

(Step [j])

Finally, the substrate was rotated at a high speed of 1500 rpm for one minute to dry it.

[Example 2-2]

A substrate laminate was prepared and cleaned in the same manner as in Example 2-1 except that temporary adhesive material composition M was used. Note that, coating was made on the substrate in accordance with the above method. The peel force of the cured layer (α) obtained by thermal curing was 96 mN/25 mm. The storage modulus of the cured layer (α) at 25°C was $2.8 \times 10^7$ Pa.

[Example 2-3]

A substrate laminate was prepared and cleaned in the same manner as in Example 2-1 except that temporary adhesive material composition O was used. Note that, coating was made on the substrate in accordance with the above method. The peel force of the cured layer (α) obtained by thermal curing was 99 mN/25 mm. The storage modulus of the cured layer (α) at 25°C was $2.8 \times 10^7$ Pa.

[Example 2-4]

A substrate laminate was prepared and cleaned in the same manner as in Example 2-1 except that temporary adhesive material composition P was used. Note that, coating was made on the substrate in accordance with the above method. The peel force of the cured layer (α) obtained by thermal curing was 99 mN/25 mm. The storage modulus of the cured layer (α) at 25°C was $3.4 \times 10^7$ Pa.

[Example 2-5]

A substrate laminate was prepared and cleaned in the same manner as in Example 2-1 except that temporary adhesive material composition Q was used. Note that, coating was made on the substrate in accordance with the above method. The peel force of the cured layer (α) obtained by thermal curing was 102 mN/25 mm. The storage modulus of the cured layer (α) at 25°C was $3.4 \times 10^7$ Pa.

[Example 2-6]

A substrate laminate was prepared and cleaned in the same manner as in Example 2-1 except that temporary adhesive material composition R was used. Note that, coating was made on the substrate in accordance with the above method. The peel force of the cured layer (α) obtained by thermal curing was 100 mN/25 mm. The storage modulus of the cured layer (α) at 25°C was $3.7 \times 10^7$ Pa.

[Comparative Example 2-1]

A substrate laminate was prepared and cleaned in the same manner as in Example 2-1 except that temporary adhesive material composition S was used. Note that, coating was made on the substrate in accordance with the above method. The peel force of the cured layer (α) obtained by thermal curing was 96 mN/25 mm. The storage modulus of the cured layer (α) at 25°C was $2.9 \times 10^7$ Pa.

[Comparative Example 2-2]

A substrate laminate was prepared and cleaned in the same manner as in Example 2-1 except that temporary adhesive material composition T was used. Note that, coating was made on the substrate in accordance with the above method. The peel force of the cured layer (α) obtained by thermal curing was 103 mN/25 mm. The storage modulus of the cured layer (α) at 25°C was $2.8 \times 10^7$ Pa.

[Comparative Example 2-3]

A substrate laminate was prepared and cleaned in the same manner as in Example 2-1 except that temporary adhesive material composition U was used. Note that, coating was made on the substrate in accordance with the above method. The peel force of the cured layer (α) obtained by thermal curing was 97 mN/25 mm. The storage modulus of the cured layer (α) at 25°C was $3.6 \times 10^7$ Pa.

[Comparative Example 2-4]

A substrate laminate was prepared and cleaned in the same manner as in Example 2-1 except that tape peeling of step [f] was not performed.

[Comparative Example 2-5]

A substrate laminate was prepared and cleaned in the same manner as in Example 2-1 except that cleaning of step [g] with cleaning solution A was not performed.

[Comparative Example 2-6]

A substrate laminate was prepared and cleaned in the same manner as in Example 2-1 except that cleaning of step [h] with cleaning solution B was not performed.

[Comparative Example 2-7]

A substrate laminate was prepared and cleaned in the same manner as in Example 2-1 except that cleaning of step [i] with cleaning solution C was not performed.

<Evaluation of particles after cleaning>

The number of particles on a substrate surface remaining after cleaning was measured by a substrate surface inspection system (trade name: WM-10, manufactured by TAKANO Co., Ltd.). The number of particles was divided by a measurement area to obtain particle distribution (an average of 5 samples). The particle-size range R to be measured was set at 100 nm or more and 1000 nm or less. If the average distribution of particles is 15 particles/cm$^2$ or less, the temporary adhesive material composition and cleaning method are evaluated to be excellent in improvement of cleanliness of a processed wafer. The results are shown in Table 2. Note that, the case where measurement was not normally completed because of an excessive number of particles was described as "not calculable", whereas a case where temporary adhesive material composition was not removed was described as "not cleaned".

[Table 2]

| Temporary | Temporary adhesive material composition | Filtration filter pore-size [nm] | Cleaning method | | | | Average distribution [particles/cm$^2$] |
|---|---|---|---|---|---|---|---|
| | | | Tape peeling | Cleaning solution A | Cleaning solution B | Cleaning solution C | |
| Example 2-1 | N | 30 | ○ | ○ | ○ | ○ | 3.8 |
| Example 2-2 | M | 50 | ○ | ○ | ○ | ○ | 6.2 |
| Example 2-3 | O | 100 | ○ | ○ | ○ | ○ | 13.6 |
| Example 2-4 | P | 50 | ○ | ○ | ○ | ○ | 5.7 |
| Example 2-5 | Q | 100 | ○ | ○ | ○ | ○ | 13.3 |
| Example 2-6 | R | 50 | ○ | ○ | ○ | ○ | 5.6 |
| Comparative Example 2-1 | S | 200 | ○ | ○ | ○ | ○ | Not calculable |
| Comparative Example 2-2 | T | 200 | ○ | ○ | ○ | ○ | Not calculable |
| Comparative Example 2-3 | U | 200 | ○ | ○ | ○ | ○ | Not calculable |
| Comparative Example 2-4 | N | 50 | - | ○ | ○ | ○ | 38.2 |
| Comparative Example 2-5 | N | 50 | ○ | - | ○ | ○ | Not cleaned |

(continued)

| Temporary | Temporary adhesive material composition | Filtration filter pore-size [nm] | Cleaning method | | | | Average distribution [particles/$cm^2$] |
|---|---|---|---|---|---|---|---|
| | | | Tape peeling | Cleaning solution A | Cleaning solution B | Cleaning solution C | |
| Comparative Example 2-6 | N | 50 | ○ | ○ | - | ○ | Not calculable |
| Comparative Example 2-7 | N | 50 | ○ | ○ | ○ | - | 124.7 |

In Table 2, Examples 2-1 to 2-6 each show the results of the case where a temporary adhesive material composition was passed through a filtration filter having a pore size of 100 nm or less and the number of particles remaining after filtration having a particle size of 100 nm or more and 1000 nm or less was 20 particles/ml or less, and the temporary adhesive material composition was removed by the cleaning method of the present invention. In any one of the cases, particle distribution after cleaning was 15 particles/$cm^2$ or less. Comparative Examples 2-1 to 2-3 each show the results of the case where a temporary adhesive material composition was passed through a filtration filter having a pore size of 200 nm and removed by the same cleaning method. In any one of the cases, the distribution was not calculated because the number of particles after cleaning was excessive. Comparative Examples 2-4 to 2-7 each show the results of the case where a temporary adhesive material composition was passed through a filtration filter having a pore size of 100 nm or less and an average number of particles remaining after filtration and having a particle size of 100 nm or more and 1000 nm or less was 20 particles/ml or less, and any one of tape peeling and cleaning steps using cleaning solutions A, B and C was not performed. In Comparative Examples 2-4, the particle distribution after cleaning was 15 particles/$cm^2$ or more. In Comparative Example 2-5, a temporary adhesive material composition was not removed. In Comparative Example 2-6, distribution was not calculated because of an excessive number of particles. In Comparative Example 2-7, distribution of particles after cleaning significantly exceeded 15 particles/$cm^2$.

INDUSTRIAL APPLICABILITY

A laminate using the temporary adhesive material composition of the present invention is processed and then the temporary adhesive material composition is removed by the cleaning method of the present invention, so that the cleanliness of a processed wafer can be improved. As a result, it is expected that the occurrence of connection failure can be suppressed in a step of laminating semiconductor chips reduced in thickness in accordance with a method of connecting copper electrodes formed on the same surface of a chip.

The present description includes the following embodiments.

[1]: A temporary adhesive material composition for detachably bonding a substrate and a support, including:

(A) an organopolysiloxane mixture that undergoes hydrosilylation reaction for crosslinking;
(B) an organopolysiloxane that undergoes no hydrosilylation reaction;
(C) a catalyst; and
(D) an organic solvent,

wherein when the temporary adhesive material composition is passed through a filtration filter having a pore size of 100 nm or less, the number of particles remaining after the filtration and having a particle size of 100 nm or more and 1000 nm or less is 20 particles/ml or less.

[2]: The temporary adhesive material composition according to the above [1], wherein

the above component (A) is a mixture of different organopolysiloxanes (A-1) and (A-2),
the component (A-1) is constituted of at least one of M unit represented by $R_1R_2R_3SiO_{1/2}$, D unit represented by $R_4R_5SiO_{2/2}$, T unit represented by $R_6SiO_{3/2}$, or Q unit represented by $SiO_{4/2}$, and substituents $R_1$, $R_2$, $R_3$, $R_4$, $R_5$, and $R_6$ are each a methyl group, $-CH=CH_2$ or a phenyl group; and
the component (A-2) is constituted of at least one of M unit represented by $R_7R_8R_9SiO_{1/2}$, D unit represented by $R_{10}R_{11}SiO_{2/2}$, T unit represented by $R_{12}SiO_{3/2}$, or Q unit represented by $SiO_{4/2}$, and substituents $R_7$, $R_8$, $R_9$, $R_{10}$, $R_{11}$, and $R_{12}$ are each a methyl group, a phenyl group or hydrogen.

[3]: The temporary adhesive material composition according to the above [1] or [2], wherein the component (B) is

constituted of at least one of M unit represented by $R_{13}R_{14}R_{15}SiO_{1/2}$, D unit represented by $R_{16}R_{17}SiO_{2/2}$, T unit represented by $R_{18}SiO_{3/2}$, or Q unit represented by $SiO_{4/2}$, and substituents $R_{13}$, $R_{14}$, $R_{15}$, $R_{16}$, $R_{17}$, and $R_{18}$ are each a methyl group or a phenyl group.

[4]: The temporary adhesive material composition according to any of the above [1] to [3], wherein the component (C) is a platinum catalyst.

[5]: The temporary adhesive material composition according to any of the above [1] to [4], wherein the component (D) is an organic solvent containing at least one saturated hydrocarbon having 8 to 12 carbon atoms and containing no heteroatoms.

[6]: A method for cleaning a substrate, including the steps of:

attaching an adhesive sheet so as to entirely cover a temporary adhesive material composition on a substrate and detaching the adhesive sheet, thereby removing the temporary adhesive material composition;
cleaning the substrate with cleaning solution A;
rinsing the substrate with cleaning solution B; and
rinsing the substrate with cleaning solution C.

[7]: The method for cleaning a substrate according to the above [6], wherein

the cleaning solution A is a cleaning solution containing a quaternary ammonium salt, and
when the cleaning solution A is passed through a filtration filter having a pore size of 100 nm or less, the number of particles remaining after the filtration and having a particle size of 100 nm or more and 1000 nm or less is 3.0 particles/ml or less.

[8]: The method for cleaning a substrate according to the above [6] or [7], wherein

the cleaning solution B is a cleaning solution containing a water-soluble organic solvent, and
when the cleaning solution B is passed through a filtration filter having a pore size of 100 nm or less, the number of particles remaining after the filtration and having a particle size of 100 nm or more and 1000 nm or less is 3.0 particles/ml or less.

[9]: The method for cleaning a substrate according to any of the above [6] to [8], wherein

the cleaning solution C is water, and
when the cleaning solution C is passed through a filtration filter having a pore size of 100 nm or less, the number of particles remaining after the filtration and having a particle size of 100 nm or more and 1000 nm or less is 3.0 particles/ml or less.

[10]: A method for cleaning a substrate, wherein
after the substrate on which the temporary adhesive material composition according to any of the above [1] to [5] is present is cleaned by the cleaning method according to any of the above [6] to [9], a distribution of particles remaining on a cleaned surface and having a particle size of 100 nm or more and 1000 nm or less is 15 particles/$cm^2$ or less.

It should be noted that the present invention is not limited to the above-described embodiments. The embodiments are just examples, and any one of the embodiments as long as it has substantially the same constitution and exerts the same function and effect as those in the technical ideas disclosed in the claims of the present invention is included in the technical scope of the present invention.

## Claims

**1.** A temporary adhesive material composition for detachably bonding a substrate and a support, comprising:

(A) an organopolysiloxane mixture that undergoes hydrosilylation reaction for crosslinking;
(B) an organopolysiloxane that undergoes no hydrosilylation reaction;
(C) a catalyst; and
(D) an organic solvent,

wherein when the temporary adhesive material composition is passed through a filtration filter having a pore size of

100 nm or less, the number of particles remaining after the filtration and having a particle size of 100 nm or more and 1000 nm or less is 20 particles/ml or less.

**2.** The temporary adhesive material composition according to claim 1, wherein

the above component (A) is a mixture of different organopolysiloxanes (A-1) and (A-2),
the component (A-1) is constituted of at least one of M unit represented by $R_1R_2R_3SiO_{1/2}$, D unit represented by $R_4R_5SiO_{2/2}$, T unit represented by $R_6SiO_{3/2}$, or Q unit represented by $SiO_{4/2}$, and substituents $R_1$, $R_2$, $R_3$, $R_4$, $R_5$, and $R_6$ are each a methyl group, $-CH=CH_2$ or a phenyl group; and
the component (A-2) is constituted of at least one of M unit represented by $R_7R_8R_9SiO_{1/2}$, D unit represented by $R_{10}R_{11}SiO_{2/2}$, T unit represented by $R_{12}SiO_{3/2}$, or Q unit represented by $SiO_{4/2}$, and substituents $R_7$, $R_8$, $R_9$, $R_{10}$, $R_{11}$, and $R_{12}$ are each a methyl group, a phenyl group or hydrogen.

**3.** The temporary adhesive material composition according to claim 1, wherein the component (B) is constituted of at least one of M unit represented by $R_{13}R_{14}R_{15}SiO_{1/2}$, D unit represented by $R_{16}R_{17}SiO_{2/2}$, T unit represented by $R_{18}SiO_{3/2}$, or Q unit represented by $SiO_{4/2}$, and substituents $R_{13}$, $R_{14}$, $R_{15}$, $R_{16}$, $R_{17}$, and $R_{18}$ are each a methyl group or a phenyl group.

**4.** The temporary adhesive material composition according to claim 1, wherein the component (C) is a platinum catalyst.

**5.** The temporary adhesive material composition according to claim 1, wherein the component (D) is an organic solvent containing at least one saturated hydrocarbon having 8 to 12 carbon atoms and containing no heteroatoms.

**6.** A method for cleaning a substrate,
comprising the steps of:

attaching an adhesive sheet so as to entirely cover a temporary adhesive material composition on a substrate and detaching the adhesive sheet, thereby removing the temporary adhesive material composition;
cleaning the substrate with cleaning solution A;
rinsing the substrate with cleaning solution B; and
rinsing the substrate with cleaning solution C.

**7.** The method for cleaning a substrate according to claim 6, wherein

the cleaning solution A is a cleaning solution containing a quaternary ammonium salt, and
when the cleaning solution A is passed through a filtration filter having a pore size of 100 nm or less, the number of particles remaining after the filtration and having a particle size of 100 nm or more and 1000 nm or less is 3.0 particles/ml or less.

**8.** The method for cleaning a substrate according to claim 6, wherein

the cleaning solution B is a cleaning solution containing a water-soluble organic solvent, and
when the cleaning solution B is passed through a filtration filter having a pore size of 100 nm or less, the number of particles remaining after the filtration and having a particle size of 100 nm or more and 1000 nm or less is 3.0 particles/ml or less.

**9.** The method for cleaning a substrate according to claim 6, wherein

the cleaning solution C is water, and
when the cleaning solution C is passed through a filtration filter having a pore size of 100 nm or less, the number of particles remaining after the filtration and having a particle size of 100 nm or more and 1000 nm or less is 3.0 particles/ml or less.

**10.** A method for cleaning a substrate, wherein
after the substrate on which the temporary adhesive material composition according to claim 1 is present is cleaned by the cleaning method according to claim 6, a distribution of particles remaining on a cleaned surface and having a particle size of 100 nm or more and 1000 nm or less is 15 particles/$cm^2$ or less.

## INTERNATIONAL SEARCH REPORT

International application No.
**PCT/JP2024/009169**

**A. CLASSIFICATION OF SUBJECT MATTER**

***C09J 183/04***(2006.01)i; ***H01L 21/304***(2006.01)i
FI: C09J183/04; H01L21/304 631

According to International Patent Classification (IPC) or to both national classification and IPC

**B. FIELDS SEARCHED**

Minimum documentation searched (classification system followed by classification symbols)

C09J183/04; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2021/112070 A1 (SHIN-ETSU CHEMICAL CO., LTD.) 10 June 2021 (2021-06-10) whole document | 1-10 |
| A | WO 2022/202153 A1 (NISSAN CHEMICAL CORPORATION) 29 September 2022 (2022-09-29) whole document | 1-10 |
| A | JP 2018-24204 A (FUJIFILM CORPORATION) 15 February 2018 (2018-02-15) paragraph [0097] | 1-5 |
| A | JP 2020-38866 A (SHIN-ETSU CHEMICAL CO., LTD.) 12 March 2020 (2020-03-12) claims, paragraphs [0124]-[0138] | 6-10 |
| A | JP 2017-79245 A (SHIN-ETSU CHEMICAL CO., LTD.) 27 April 2017 (2017-04-27) paragraphs [0085]-[0103], [0132]-[0133] | 6-10 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 May 2024** | **21 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No. **PCT/JP2024/009169**

**Box No. III Observations where unity of invention is lacking (Continuation of item 3 of first sheet)**

This International Searching Authority found multiple inventions in this international application, as follows:

(Invention 1) Claims 1-5

Claims 1-5 have the special technical feature wherein, in a temporary bonding material composition releasably bonding a substrate with a support, when the temporary bonding material composition is passed through a filter having a pore diameter of 100 nm or less, the number of particles having a diameter of 100 nm-1,000 nm inclusive remaining after the filtration is 20 particles/ml or less, and thus are classified as invention 1.

(Invention 2) Claims 6-10

Claims 6-9 do not share a technical feature with claim 1 classified as invention 1 and do not share a same or corresponding special technical feature with claim 1.

In addition, claim 6-9 are not dependent on claim 1 and are not substantially identical to or similarly closely related to any of the claims classified as invention 1.

Claims 6-9 therefore cannot be classified as invention 1.

Claims 6-9 have the special technical feature of a method for cleaning a substrate, the method comprising a step for adhering an adhesive sheet so that the adhesive sheet covers all over a temporary bonding material composition on a substrate and peeling the adhesive sheet to remove the temporary bonding material composition, a step for cleaning the substrate with a cleaning solution A, a step for rinsing the substrate with a cleaning solution B and a step for rinsing the substrate with a cleaning solution C, and thus are classified as invention 2.

Although claim 10 is dependent on claim 1 and claim 6, claim 10 is the invention pertaining to a method for cleaning a substrate, and thus is classified as invention 2 together with claims 6-9.

1. ☑ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☑ No protest accompanied the payment of additional search fees.

Form PCT/ISA/210 (continuation of first sheet) (July 2022)

**INTERNATIONAL SEARCH REPORT**
**Information on patent family members**

International application No.
**PCT/JP2024/009169**

| Patent document cited in search report | Publication date (day/month/year) | Patent family member(s) | Publication date (day/month/year) |
|---|---|---|---|
| WO 2021/112070 A1 | 10 June 2021 | US 2023/0002647 A1<br>whole document<br>EP 4071223 A1<br>KR 10-2022-0108799 A<br>CN 114868232 A<br>TW 202134386 A | |
| WO 2022/202153 A1 | 29 September 2022 | EP 4317338 A1<br>whole document<br>CN 117120573 A<br>KR 10-2023-0161989 A<br>TW 202237791 A | |
| JP 2018-24204 A | 15 February 2018 | (Family: none) | |
| JP 2020-38866 A | 12 March 2020 | US 2020/0075388 A1<br>claims, paragraphs [0141]-[0167]<br>EP 3618102 A2<br>CN 110875235 A<br>KR 10-2020-0026727 A<br>TW 202027155 A | |
| JP 2017-79245 A | 27 April 2017 | US 2017/0110360 A1<br>paragraphs [0087]-[0106], [0136]-[0137]<br>EP 3159924 A1<br>KR 10-2017-0045720 A<br>CN 106952854 A<br>TW 201731997 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013243350 A